# EUROPEAN PATENT APPLICATION

(11) **EP 4 394 869 A1**
(43) Date of publication of application: **03.07.2024**
(21) Application number: 23204827.2
(22) Date of filing: 20.10.2023
(51) Int. Cl.: H01L 25/075, H01L 25/16

(54) **DISPLAY DEVICE AND TILING DISPLAY DEVICE INCLUDING THE SAME**

(30) Priority: 30.12.2022 KR 20220191262
(71) Applicant: LG Display Co., Ltd., Seoul 07336 (KR)
(72) Inventor: SONG, Changhyun, 10845 Paju-si, Gyeonggi-do (KR); KIM, Minseok, 10845 Paju-si, Gyeonggi-do (KR); KIM, Jongsung, 10845 Paju-si, Gyeonggi-do (KR); LEE, Jaewon, 10845 Paju-si, Gyeonggi-do (KR)
(74) Representative: Viering, Jentschura & Partner mbB Patent- und Rechtsanwälte

(57) **Abstract**

Disclosed is a display device (100, 200, 300, 400, 500, 600) including a substrate (FSUB) comprising a front panel region (FPN), a rear panel region (BPN) and a bending region (BDA) disposed between the front panel region (FPN) and the rear panel region (BPN); a display region (AA) located in the front panel region (FPN), a plurality of light emitting elements (ED) being disposed on the display region (AA); an integrated circuit chip (IC) disposed on the rear panel region (BPN); and connection wires (LE) extending from the front panel region (FPN) to the rear panel region (BPN) of the substrate (FSUB) through the bending region (BDA), and the rear panel region (BPN) of the substrate (FSUB) may be secured to a lower portion of the substrate (FSUB) that corresponds to the front panel region (FPN).

## Description

### BACKGROUND

### Field

The present disclosure relates to a display device, more particularly, a display device and a tiling apparatus including the same.

### Description of Related Art

Display devices are applied to various electronic devices such as TVs, mobile phones, laptops and tablets. To this end, research to develop thinning, lightening and low power consumption of display devices is being continued.

Among display devices, a light emitting display device has a light emitting element or light source embedded therein and displays information through light generated from the embedded light emitting element or light source. A display device including a self- light emitting (i.e., luminescent) element may have an advantage of realizing a thinner display device than a display device having an embedded light source, and another advantage of realizing a flexible display device that can be folded, bent or rolled.

The display device having the embedded luminescent element may include an OLED (Organic Light Emitting Display) having an organic material disposed as a light emitting layer or Micro LED (Micro Light Emitting Diode) having an inorganic material disposed as a light emitting layer. Here, the organic light emitting display requires a separate light source but has a disadvantage of defective pixels that might easily occur due to external environment of organic materials vulnerable to moisture and oxygen. As it uses an inorganic material resistant to moisture and oxygen as a light emitting layer, the micro LED display device is not affected by the external environment and has high reliability and a long lifespan, compared to the organic light emitting display device.

### SUMMARY

The micro LED display device is resistant to external environment, may require less or no protective structure such as a sealing material and uses various materials as a substrate material, thereby realizing a flexible display device even with a thinner structure than an organic light emitting display device. Accordingly, the micro LED display device according to the present disclosure may easily realize a tiling display device by aligning a plurality of micro LED display devices in horizontal and vertical directions.

When realizing a tiling display device by aligning the plurality of micro LED display devices in the horizontal and vertical directions, an upper substrate on which a light emitting element is disposed and a lower substrate on which a chip-on-film is disposed are bonded together and side wires for electrically connecting the upper substrate and the lower substrate with each other are formed through a separate process.

However, if the upper and lower substrates bonded to each other are bent, the side wires might be disconnected and this might lead to product defects and defects might occur even in the process of forming the side wiring through a separate process.

Accordingly, one objective of the present disclosure is invented to solve the above-noted disadvantages of the prior art, and to provide a micro LED display device that may realize a display region where an image is displayed and a peripheral area where signals are transmitted to the display area by using one substrate, instead of using separate upper and lower substrates.

Another objective of the present disclosure is to provide a display device that may realize a lightweight product by introducing a lightweight material to a substrate.

A further objective of the present disclosure is to provide a display device that may optimize processes by omitting a process of separately manufacturing the lower substrate.

Objects of the present disclosure are not limited to the above-described objects, and other objects and advantages of the present invention will be understood by the following description and will be more definitely understood through the embodiments of the present disclosure. It is also to be easily understood that the objectives and advantages of the present disclosure may be realized and attained by means and a combination thereof described in the appended claims.

According to an aspect of the present disclosure, a display device according to claim 1 is provided. Further embodiments are described in the dependent claims. A display device according to an embodiment of the present disclosure may include a substrate comprising a front panel region, a rear panel region and a bending region disposed between the front panel region and the rear panel region; a display region located in the front panel region, a plurality of light emitting elements being disposed on the display region; an integrated circuit chip disposed on the rear panel region; and connection wires extending from the front panel region to the rear panel region of the substrate through the bending region. The rear panel region of the substrate may be secured to a lower portion of the substrate that corresponds to the front panel region.

A tiling display device according to an embodiment of the present disclosure may include a plurality of display devices. The plurality of display devices may be disposed to position bending regions of substrates adjacent to each other.

In one embodiment, a display device includes a substrate including a front panel region, a rear panel region, and a bending region between the front panel region and the rear panel region, the substrate having a first surface and a second surface, and wherein the substrate is bent such that the second surface of the rear panel region faces the second surface of the front panel region of the substrate. The display device further includes a set of light emitting elements disposed on a display region of the front panel region of the substrate, wherein the set of light emitting elements include micro light emitting diodes (LED's). The display device further includes first connection wires on the front panel region of the substrate, the first connection wires electrically connected to the set of light emitting elements. The display device further includes side wires extending from the first connection wires on the bending region of the substrate, wherein a width of a side wire is wider than a width of a first connection wire or a width of a second connection wire. The display device further includes second connection wires extending from the side wires on the rear panel region of the substrate, the second connection wires electrically connected to an integrated circuit chip.

In one embodiment, a display device includes a substrate comprising a front panel region, a rear panel region, and a bending region between the front panel region and the rear panel region. The display device includes a thin film transistor on the substrate, the thin film transistor including an active layer, a gate insulating layer, a gate electrode, a source electrode, and a drain electrode. The display device further includes an interlayer insulating film on the gate electrode of the thin film transistor. The display device further includes a connection electrode on the interlayer insulating film, the connection electrode electrically connected to the thin film transistor. An adhesive layer may be on the connection electrode, the adhesive layer including adhesive material. The display device further includes a planarization layer on the adhesive layer, wherein the adhesive layer and the planarization layer is formed with a contact hole exposing at least a portion of the connection electrode. The display device further includes at least one micro light emitting diode (micro LED) disposed on at least a portion of the adhesive layer, the micro LED device including a semiconductor layer and another semiconductor layer. The display device further includes a wire electrode electrically connecting the semiconductor layer of the micro LED and the connection electrode through the contact hole.

In one embodiment, a display device includes a substrate including a front panel region, a rear panel region, and a bending region between the front panel region and the rear panel region. The display device further includes one or more thin film transistors, a first insulating layer on the adhesive layer. The display device further includes a connection electrode on the first insulating layer, the connection electrode electrically connected to the one or more thin film transistors. The display device further includes at least one micro light emitting diode (micro LED) disposed on at least a portion of the adhesive layer, the micro LED including a semiconductor layer and another semiconductor layer. The display device further includes a second insulating layer on the first insulating layer, wherein the second insulating layer is formed with a contact hole exposing at least a portion of the connection electrode. The display device further includes a wire electrode electrically connecting the semiconductor layer of the micro LED and the connection electrode through the contact hole, and a bank on the second insulating layer, wherein the bank fills at least a portion of the contact hole, wherein the bank includes a black material.

The display device according to an embodiment of the present disclosure may have an advantageous effect of optimizing whole processes by omitting the process of separately manufacturing the lower substrate.

In addition, the display device may form the wiring for applying a signal to the light emitting elements on the display region and the side wire from the front panel area to the rear panel area, without being cut off. Accordingly, it is possible to prevent the side wire from being disconnected during the bending process, thereby improving the reliability of the product.

In addition, the display device may prevent the disconnecting of the side wire, thereby realizing display devices having various shapes such as a curved display device.

In addition, the display device may form the light emitting element, the thin film transistor, the chip-on-film including the circuit film, on which the integrated circuit chip is embedded, on one substrate, thereby omitting the plurality of processes which results in process optimizing and costs reduction.

In addition, the display device may use one substrate by introducing the lightweight material, thereby realizing a lightweight product.

In addition to the above-described effects, specific effects of the present disclosure will be described together with the following detailed description for implementing the present disclosure.

### BRIEF DESCRIPTION OF DRAWINGS

FIG. 1 is a schematic plane view of a tiling display device according to an embodiment of the present disclosure.
FIG. 2 is a schematic perspective view along line 2-2 in FIG. 1, according to an embodiment of the present disclosure.
FIG. 3 is a plane view showing a display device shown in FIG. 2 being unfolded, according to an embodiment of the present disclosure.
FIG. 4 is a sectional view along line 4-4 of FIG. 2, according to an embodiment of the present disclosure.
FIG. 5 is an enlarged view of region 5 in FIG. 4, according to an embodiment of the present disclosure.
FIG. 6 is a sectional view of a display device according to another embodiment of the present disclosure.
FIG. 7 is a sectional view of a display device according to a further embodiment of the present disclosure.
FIGS. 8 to 11 are views showing a method of manufacturing a display device according to an embodiment of the present disclosure.
FIGS. 12 to 14 are views showing a method of manufacturing a display device according to another embodiment of the present disclosure.
FIGS. 15 to 18 are views showing a method of manufacturing a display device according to a further embodiment of the present disclosure.
FIG. 19 is a plane view showing that a display device according to a further embodiment of the present disclosure is unfolded.
FIGS. 20 to 24 are views to describe a manufacturing method of a display device according to a further embodiment of the present disclosure.
FIGS. 25 to 28 are views to describe a manufacturing method of a display device according to a further embodiment of the present disclosure.
FIG. 29 is a view showing a wearable device including a display device according to a further embodiment of the present disclosure.

### DETAILED DESCRIPTION

Advantages and features of the present disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to completely inform the scope of the present disclosure to those of ordinary skill in the technical field to which the present disclosure belongs.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for describing embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "coupled to", or "connected to" another element or layer, it may be directly on, coupled to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the spirit and scope of the present disclosure.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is a separate explicit description thereof.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects," and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for describing embodiments.

Further, in a specific case, a term may be arbitrarily selected by the applicant, and in this case, the detailed meaning thereof will be described in a corresponding description section. Therefore, the terms used in the description below should be understood based on not simply the name of the terms, but the meaning of the terms and the contents throughout the Detailed Description.

Hereinafter, a display device according to each embodiment of the present disclosure will be described with reference to the accompanying drawings.

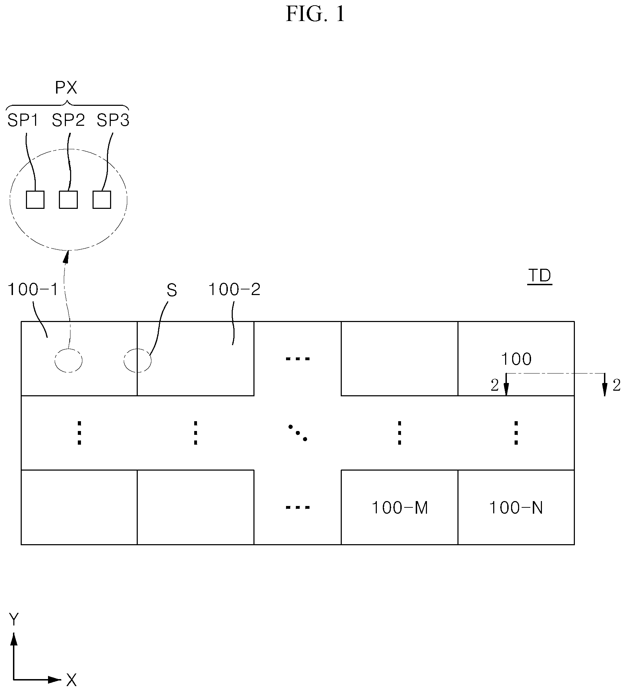

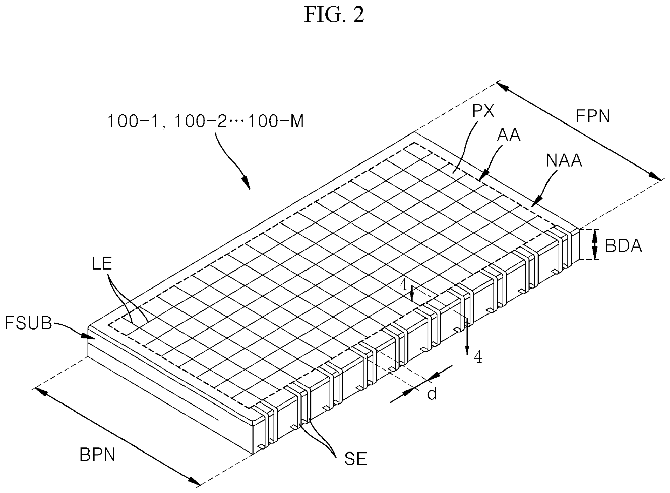

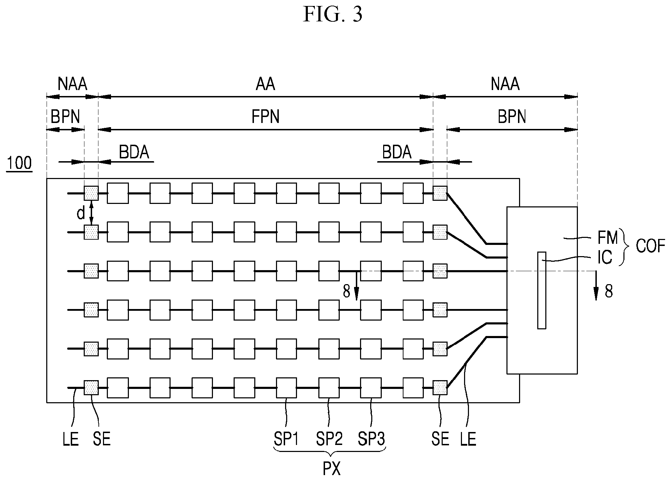

FIG. 1 is a schematic plane view of a tiling display device according to an embodiment of the present disclosure. FIG. 2 is a schematic perspective view along line 2-2 in FIG. 1, according to an embodiment of the present disclosure. FIG. 3 is a plane view showing a display device shown in FIG. 2 being unfolded, according to an embodiment of the present disclosure. Here, FIG. 2 shows only side wire (SE) for description convenience.

Referring to FIGS. 1 to 3, a tiling display device (i.e., TD) according to an embodiment of the present disclosure may include a plurality of display devices 100, 100-1, 100-2, 100-3... 100-M, and 100-N. In this instance, M and N may be natural numbers. Each of the display devices 100-1, 100-2, 100-3... 100-M and 100-N is connected with adjacent ones to contact in a first direction X and a second direction Y crossing the first direction X. At this time, the first direction X may be a horizontal direction and the second direction Y may be a vertical direction.

A plurality of pixels PX may be provided in the plurality of display devices 100, 100-1, 100-2, 100-3... 100-M, and 100-N. The plurality of pixels may include a plurality of sub-pixels SP1, SP2 and SP3. The plurality of sub-pixels SP1, SP2 and SP3 may include a first light emitting element, a second light emitting element and a third light emitting element that emit red light R, green light G and blue light B, respectively. However, the embodiment is not limited thereto and the light emitting elements may further include a white light emitting element. The light emitting element according to the embodiment of the present disclosure may be Micro LED. The micro LED may be an LED made of an inorganic material understood as a light emitting element that has a thickness of 100 µm or less or a growth substrate for growing the LED removed therefrom.

Meanwhile, when realizing the tiling display device TD by connecting the plurality of display devices 100-1, 100-2, 100-3... 100-M, and 100-N, a distance between one PX disposed at the outermost position of one display device and one PX disposed at the outermost position of an adjacent display device may be equal to a distance between PXs disposed in each display device. Accordingly, a minimum bezel area or a zero bezel area having substantially no bezel area may be realized. If the space occupied by the bezel is reduced or minimized, the display region may increase and a user can recognize that images continuously appear without interruption so that the user's screen immersion may increase.

In this instance, the quality of the displayed image may be improved by realizing a side structure of the display device which is configured to hide a seam region S, which is a boundary area between two adjacent display devices not to be recognized by the user. For example, referring to FIGS. 2 and 3, each of the display devices 100-1, 100-2, 100-3 ... 100-M and 100-N may have one substrate FSUB provided as one sheet.

The substrate FSUB may include a display region AA and a non-display region NAA surrounding the display region AA. The substrate FSUB may include a front panel region FPN, a bending region BDA and a rear panel region BPN, and may be one sheet substrate. The bending region BDA is a portion that is bendable so that the rear panel region BPN may face the front panel region FPN. At least one bending region BDA may be disposed between the front panel region FPN and the rear panel region BPN.

In the front panel region FPN may be disposed a plurality of pixels PX including a plurality of sub-pixels SP1, SP2 and SP3, on which light emitting elements emitting light to the display region are disposed, and connection wires for transmitting a signal to the pixels PX. In the rear panel region BPN may be disposed a chip-on-film COF including a circuit film FM, on which an integrated circuit chip for transmitting drive signals to the sub-pixels SP1, SP2 and SP3, and connection wires LE are disposed. Side wires SE extending from the connection wires LE may be disposed on the bending region BDA connected to the rear panel region BPN from the front panel region FPN. Adjacent side wires SE may be spaced a preset distance d apart from each other.

The side wires SE disposed on the bending region BDA may have the width that is relatively larger than the width of the connection wires LE disposed on the front panel region FPN and the rear panel region BPN. Accordingly, the side wires SE may be prevented from being damaged in the bending process such as disconnection, which will be described again later.

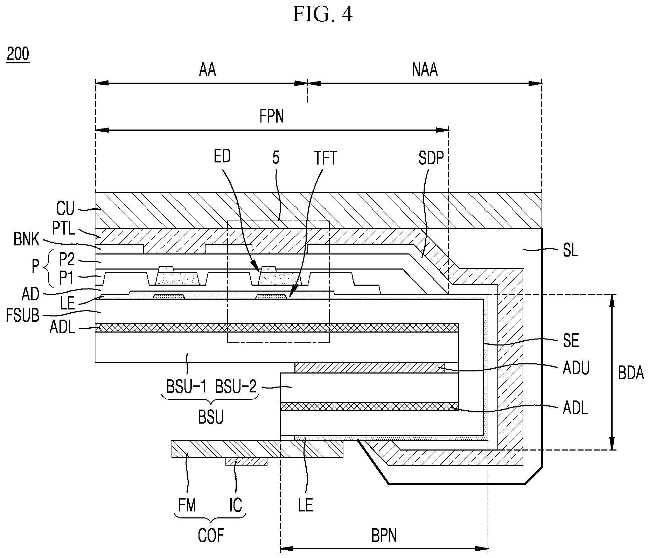

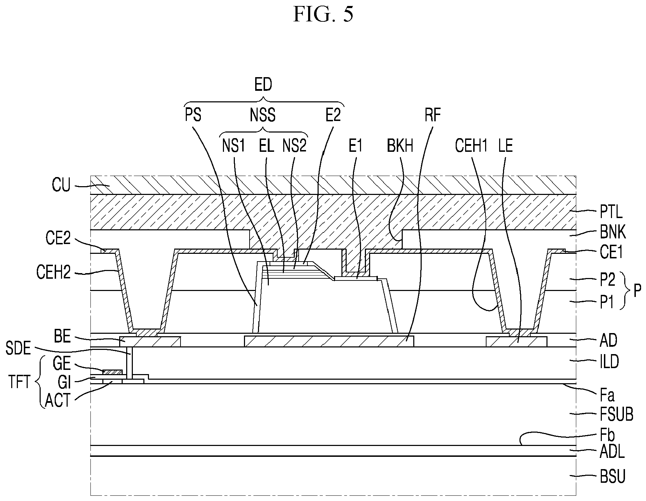

FIG. 4 is a sectional view along a 4-4 line of FIG. 2, according to an embodiment of the present disclosure. FIG. 5 is an enlarged view of region 5 in FIG. 4, according to an embodiment of the present disclosure. At this time, a light emitting element ED disposed at the outermost position of the display device is shown in the drawings for description convenience.

Referring to FIGS. 4 and 5, a display device 200 according to an embodiment of the present disclosure may be configured of a single substrate FSUB. The substrate FSUB may include a front panel region FPN, a rear panel region BPN, and a bending region BDA disposed between the front panel region FPN and the rear panel region BPN. The substrate FSUB may have the bending region BDA bending so that the rear panel region BPN and the front panel region FPN face each other in contact. The substrate FSUB may thus be bent such that the second surface Fb of the rear panel region BPN faces the second surface Fb of the front panel region FPN of the substrate FSUB.

The substrate FSUB may be made of a transparent insulating material with flexibility. For example, the substrate FSUB may contain polyimide (PI) and the material of the substrate may be modified in various examples within a property of transparency with flexibility.

In the front panel region FPN of the substrate FSUB, a light emitting element ED for emitting light to the display region AA and a thin film transistor TFT for driving the light emitting element ED may be disposed. In the rear panel region BPN, a chip-on-film COF including a circuit film FM, on which an integrated circuit chip IC is mounted, and connection wires LE for transmitting driving signals to the light emitting element ED and the thin film transistor TFT may be disposed. In the bending region BPN, side wires SE may be disposed. In one embodiment, at least one COF is disposed on at least a portion of the rear panel region BPN of the substrate FSUB.

As one example, the light emitting element ED may be disposed on a front panel region FPN. As another example, the light emitting element ED may be extendedly disposed from the front panel region FPN to a partial area of the bending region BPN between the front panel region FPN and the rear panel region BPN. In this instance, since the light emitting element ED is extendedly disposed even in the partial area of the bending region BPN, the entire area of the display area AA occupying the display device may increase.

A support member BSU may be disposed on a rear surface of the substrate FSUB via a coupling member ADL. The support member BSU may include a first support unit BSU-1 disposed at a position corresponding to the front panel region FPN and a second support unit BSU-2 disposed at a position corresponding to the rear panel region BPN. The support member BSU may be made of a material having a predetermined rigidity, compared with the substrate FSUB and it may include glass or plastic, for example. The first support unit BSU-1 may be coupled to the second surface Fb of the front panel region FPN of the substrate FSUB (e.g., via coupling member ADL) and the second support unit BSU-2 may be coupled to the second surface Fb of the rear panel region BPN of the substrate FSUB (e.g., via coupling member ADL).

The second support unit BSU-2 may be attached to the first support unit BSU-1 by using an adhesive member ADU to be secured to a lower portion of the front panel region FPN.

The rear panel region BPN of the substrate FSUB may be a lower portion of the substrate FSUB corresponding to the front panel region FPN. One lateral surface of the first support unit BSU-1 and one lateral surface of the second support unit BSU-2 may be in contact with an exposed rear surface of the substrate FSUB by the configuration in which a portion of the substrate FSUB corresponding to the bending region BDA is folded.

The connection wires LE may be configured to transmit driving signals to the light emitting element ED and the thin film transistor TFT. The connection wires LE may extend from the front panel region FPN to the rear panel region BPN, without being cut off. The connection wires LE may extend from the front panel region FPN of the substrate to the rear panel region BPN through the bending region BDA. A portion of the connection wires LE positioned on the bending region BDA may be called side wires SE. In one embodiment, first connection wires LE may be disposed on the front panel region FPN of the substrate FSUB, in which the first connection wires LE are electrically connected to a set of light emitting elements ED. Side wires SE extending from the first connection wires LE may be disposed on the bending region BDA of the substrate FSUB. Second connection wires LE extending from the side wires SE may be disposed on the rear panel region BPN of the substrate FSUB, in which the second connection wires LE are electrically connected to an integrated circuit chip.

On the substrate FSUB may be disposed the light emitting element ED, the thin film transistor TFT for driving the light emitting element ED, and various wires. Hereinafter, referring to FIG. 5 that is an enlarged view of the area on which the light emitting element ED of FIG. 4 is disposed, the present disclosure will be described. Referring to FIG. 5, the thin film transistor TFT configured to drive the light emitting element ED may be disposed on a first surface Fa of the substrate FSUB. A second surface Fb is a rear surface of the first surface Fa of the substrate FSUB. A support member BSU may be disposed on a lower portion of the second surface Fb. The first surface Fa may be referred to as a front surface and the second surface Fb may be referred to as a rear surface.

The support member BSU may be disposed in a direction of the second surface Fb of the substrate FSUB and configured to support the substrate FSUB. The support member BSU may be disposed on a lower portion of the second surface Fb of the substrate FSUB via a coupling member ADL. The coupling member ADL may include an adhesive or a double-sided tape, for example.

The thin film transistor TFT may include a semiconductor layer ACT formed on the first surface Fa of the substrate FSUB, a gate electrode GE disposed on the semiconductor layer ACT, and a gate insulating layer G1 disposed between the semiconductor layer ACT and the gate electrode GE.

The semiconductor layer ACT may include an active region overlapping the gate electrode GE to form a channel, and a source region and a drain region that are disposed on both sides with respect to the active region interposed therebetween. An interlayer insulating film ILD may be disposed on the gate electrode GE. The interlayer insulating film ILD may include a source/drain electrode electrically connected with a source/drain region of the semiconductor layer ACT through the gate insulating layer GI. In one embodiment, the interlayer insulating film ILD may include organic material.

A connection electrode BE, connection wires LE and a reflection layer RF may be disposed on the interlayer insulating film ILD. The connection electrode BE, the connection wires LE and the reflection layer RF may be disposed on the same plane. As an example, the connection wires LE may include a common voltage line. An adhesive layer AD for covering the connection electrode BE, the connection wires LE and the reflection layer RF may be disposed on the interlayer insulating film ILD. The adhesive layer AD may selectively expose upper surfaces of the connection electrode BE and the connection wires LE.

The light emitting element ED may be disposed at a position on the adhesive layer AD, corresponding to the position of the reflection layer RF. The horizontal micro LED has been described as one example of the light emitting element according to the embodiment of the present disclosure but the present disclosure is not limited thereto. For example, a vertical micro LED or a flip-chip type micro LED may be applied as the light emitting element.

The light emitting element ED may include a nitride semiconductor structure NSS, a passivation layer PS, a first electrode E1 and a second electrode E2. The nitride semiconductor structure NSS may include a first semiconductor layer NS1, an active layer EL disposed on a predetermined area of the first semiconductor layer NS1, and a second semiconductor layer NS2. The passivation layer PS may be disposed outside the nitride semiconductor structure NSS. The first electrode E1 may be connectedly disposed on the first semiconductor layer NS1 and the second electrode may be connectedly disposed on the second semiconductor layer NS2. In one embodiment, the passivation layer PS may cover a side surface of the first semiconductor layer NS1 and/or the second semiconductor layer NS2.

The first semiconductor layer NS 1 may be a layer for supplying electrons to the active layer EL, and may include a nitride semiconductor containing first conductivity type impurities. For example, the first conductivity type impurities may include N-type impurities. The active layer EL disposed on a predetermined portion of the first semiconductor layer NW1 may have a MQW (Multi Quantum Well) structure. The second semiconductor layer NS2 may be a layer for injecting holes in the active layer EL. The second semiconductor layer NS2 may include a nitride semiconductor containing second conductivity type impurities. For example, the second conductivity type impurities may include P-type impurities.

Among the light emitting from the light emitting element ED, the reflection layer RF may be configured to reflect the light emitted to the second surface Fb as the rear surface of the substrate FSUB, to the light emitting region of the first surface Fa as the front surface. In one embodiment, the reflection layer RF may be disposed below the light emitting element ED, e.g., micro LED, and in a further embodiment, may be disposed below the adhesive layer.

The light emitting element ED may be covered with a planarization layer P. The planarization layer P may have a predetermined thickness that is enough to planarize an upper surface that is stepped by circuit elements. The planarization layer P may include a structure in which a first planarization layer P1 and a second planarization layer P2 are layered. The planarization layer P may include a negative type photoactive compound.

The planarization layer P may have a first contact hole CEH1 and a second contact hole CEH2, which penetrate the first planarization layer P1 and the second planarization layer P2, to partially expose to surfaces of the first electrode E1 and the second electrode E2 of the light emitting element ED. In one embodiment, a second contact hole CEH2 formed in the planarization layer P exposes at least a portion of the connection electrode BE, and/or a first contact hole CEH1 in the planarization layer P exposes at least a portion of the connection wire LE. In one embodiment, the planarization layer P may cover a side surface of the passivation layer PS.

A first wire electrode CE1 and a second wire electrode CE2 may be disposed on the exposed surfaces of the first contact hole CEH1 and the second contact hole CEH2, respectively, to be electrically connected to the connection wire LE or the drain electrode of the semiconductor layer ACT of the thin film transistor TFT, respectively. The first wire electrode CE1 may be electrically connected with the first electrode E1. The second wire electrode CE2 may be electrically connected with the second electrode E2. The first wire electrode CE1 and the second wire electrode CE2 may be made of the same material. In an embodiment, the first wire electrode CE1 or the second wire electrode CE2 may include a transparent metal oxide such as indium-tin-oxide (ITO) or indium-zinc-oxide (IZO).

A bank BNK having a bank hole BKH may be disposed on the planarization layer P. The bank BNK may be a boundary region defining the light emitting region, and configured to divide sub-pixels, on which the light emitting elements ED are disposed, respectively, from each other. In an embodiment, a material constituting the bank BNK may be filled in the first contact hole CEH1 and the second contact hole CEH2, in which the first wire electrode CE1 and the second wire electrode CE2 are formed, respectively. The bank BNK may be configured of a black matrix. A sealing insulation layer PTL including the bank BNK may be disposed on the substrate FSUB. In one embodiment, the bank BNK may include a black material, such as carbon black or black pigments. In one embodiment, the sealing insulation layer PTL may cover the bank BNK, the planarization layer P, and the wire electrodes CE1 or CE2. In one instance, the planarization layer P is an insulating layer.

Referring to FIG. 4 again, the bank BNK may extend from an outermost portion of the front panel region FPN to the rear panel region FPN. Here, the area extended from the outermost point of the front panel region FPN to the rear panel region BPN may be referred to as a side wire protection layer SDP. The side wire protection layer SDP may be formed to cover the exposed surface of the side wire SE disposed on the bending region BDA. In one instance, the bank BNK may extend to cover at least a portion of the front panel region FPN, the rear panel region BPN, and the bending region BDA.

The sealing insulating layer PTL may be formed by extending from the outermost point of the front panel region FPN to a predetermined area of the rear panel region BPN. The sealing insulating layer PTL may be configured to cover all the exposed surface of the side wire protection layer SDP disposed on the bending region BDA. Accordingly, the side wires SE may be protected from an external shock by the side wire protection layer SDP and the sealing insulating layer PTL.

A cover member CU may be disposed on the sealing insulating layer PTL. The cover member CU may be disposed on at least the sealing insulating layer PTL on the front panel region. The cover member CU may include a functional optical film such as an anti-shattering film.

A side sealing member SP may be disposed on at least one lateral surface of the substrate FSUB. The side sealing member SL may be configured to protect the side wires SE of the display device and prevent moisture penetration of moisture or the like from the lateral surface. An outer surface of the side sealing member SL may be disposed on the same plane with the outermost surface of the cover member CU to form alignment.

Since the connection wires LE and the side wires SE extend from the front panel region FPN to the rear panel region BPN without being cut off, the display device according to an embodiment of the present disclosure may prevent the disconnection of the side wires SE in the bending region BDA and improve the product reliability.

Instead of bonding the upper and lower substrates made of a relatively hard material such as glass, the display device may introduce a flex and light material such as polyimide to the substrate as single substrate to realize a lightweight product.

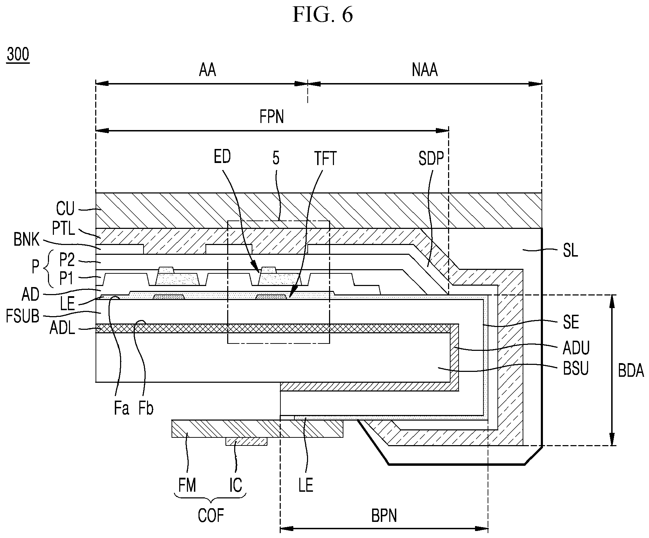

FIG. 6 is a sectional view of a display device according to another embodiment of the present disclosure.

Referring to FIG. 6, a display device 300 according to another embodiment of the present disclosure is the same as the display device 200 according to the embodiment of FIG. 4, except the area of the substrate FSUB exposed to the second surface Fb by removing the support member BSU, and repeated description of this embodiment is omitted hereinafter.

Referring to FIG. 6, the display device 300 according to this embodiment may have an adhesive member ADU that is disposed on the exposed area of the substrate FSUB to the second surface Fb. A bending region BDA of the substrate FSUB and the rear panel region BPN may be secured to a lower portion of the front panel region FPN through the adhesive member ADU. In one embodiment, a single support member BSU may be coupled to the second surface Fb of the front panel region FPN and the rear panel region BPN of the substrate FSUB (e.g., via coupling member ADL or adhesive layer ADU).

Accordingly, a distance between the front panel region FPN and the rear panel region BPN of the substrate FSUB may be reduced so that a thinner display device 300 may be realized.

Meanwhile, heat generated from the display device may be more easily discharged and the rigidity of the substrate FSUB may be further secured by changing the material of the support member BSU.

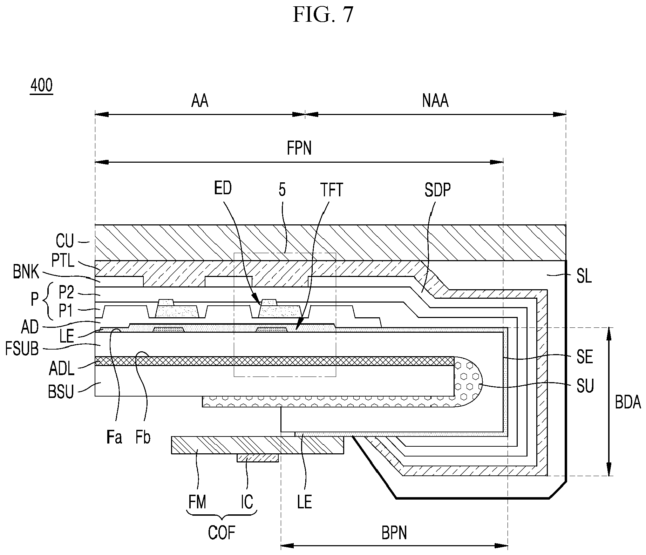

FIG. 7 is a sectional view of a display device according to another embodiment of the present disclosure.

Referring to FIG. 7, a display device 400 according to a further embodiment of the present disclosure may use a different material for the support member BSU and further include a reinforcing member SU, which is different from the display device 300 according to the embodiment of FIG. 6.

The display device 400 according to the embodiment of the present disclosure may be characterized in that the planarization layer P covering the light emitting element ED on the substrate FUB extends even to the rear panel region BPN, different from the display device 300 according to the embodiment of FIG. 6. Specifically, the multilayered structure of the first planarization layer P1 and the second planarization layer P2 may extend some area of the rear panel region BPN, while covering the bending region BDA.

Accordingly, repeated description in comparison between the display devices 200 and 300 according to the embodiments will be omitted.

As shown in FIG. 7, the support member BSU disposed under the second surface Fb of the substrate FSUB of the display device 400 according to the embodiment may include a metal material. In an embodiment, the support member may be made of a material that may easily dissipate heat such as aluminum Al. Accordingly, the heat generated inside the display device may be easily dissipated to the outside through the support member BSU.

A reinforcing member SU may be disposed on a lower surface and a lateral surface of the support member BSU disposed at a position corresponding to the front panel region FPN. The reinforcing member SU may be made of a relatively harder material than the material of the substrate FSUB. In an embodiment, the reinforcing member SU may include mandrel. The reinforcing member SU may be secured to the support member BSU by using an adhesive. Accordingly, the rigidity of the substrate FSUB may be improved.

As the bending region BDA on which the side wires SE are disposed is covered with the planarization layer P, the side wire protection layer SDP and the sealing insulating layer PTL, the side wires SE disposed on the lateral surface of the display device 400 may be prevented from being damaged by an external shock.

Hereinafter, referring to the accompanying drawings, a manufacturing method according to embodiments of the present disclosure will be described.

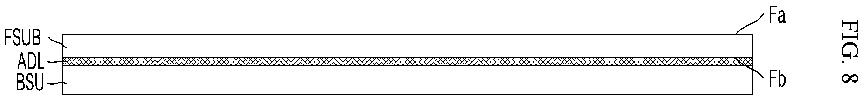

FIGS. 8 to 11 are views showing a method of manufacturing a display device according to an embodiment of the present disclosure. Here, FIG. 8 is a sectional view along a line 8-8 shown in FIG. 3.

Referring to FIG. 8, the substrate FSUB is prepared. The substrate FSUB may be made of a transparent insulating material with flexibility for easily bending the substrate FSUB. The substrate FSUB may include polyimide PI and the present disclosure is not limited thereto. For example, any transparent materials may be applied without being limited. The substrate FSUB may include the first surface Fa and the second surface Fb that is a rear surface of the first surface Fa.

On the substrate FSUB may be disposed the thin film transistor TFT for driving the light emitting element ED and the support member BSU for reinforcing the rigidity of the substrate FSUB to form various wires.

The support member BSU may be disposed on the second surface Fb that is the rear surface of the first surface Fa of the substrate FSUB. The support member BSU may be made of a relatively harder material than the material of the substrate FSUB, for example, glass or plastic.

A coupling member ADL may be disposed between the substrate FSUB and the support member BSU, to secure the support member BSU to the substrate FSUB. The coupling member ADL may include an adhesive or a double-sided tape.

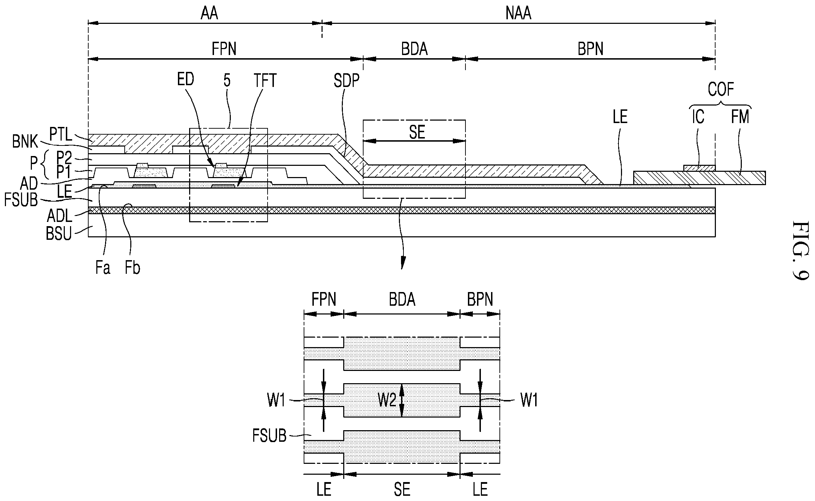

Referring to FIG. 9, the light emitting element ED, the thin film transistor TFT for driving the light emitting element ED, and various wires may be disposed on the substrate FSUB having a flat unfolded shape.

The embodiments of the present disclosure may suggest a lateral-type micro LED as the light emitting element ED formed on the substrate FSUB but are not limited thereto. For example, the light emitting element ED may be configured of the vertical-type micro LED.

When the light emitting element ED is the vertical-type micro LED, the thin film transistor TFT and the light emitting element ED have the same configuration as the micro LED and the thin film transistor TFT described in FIG. 7. Accordingly, detailed description thereof will be omitted.

The substrate FSUB may include the display region AA and the non-display region NAA. It may be understood that the display region AA may be a region on which an image is displayed and the non-display region NAA is a region on which an image is not displayed. In the non-display region NAA, wires for transmitting a signal to the light emitting element ED and the thin film transistor TFT and a chip-on-film COF including a circuit film FM on which an integrated circuit chip IC is mounted may be disposed.

The substrate FSUB may include the front panel region FPN, the bending region BDA and the rear panel region BPN. The light emitting element ED for emitting light to the display region and the thin film transistor TFT for driving the light emitting element ED may be disposed on the front panel region FPN. The chip-on-film COF including the circuit film FM, on which the integrated circuit chip IC is mounted, and the wires for transmitting a driving signal to the light emitting element ED and the thin film transistor TFT may be disposed on the rear panel region BPN.

The chip-on-film COF including the integrated circuit chip IC may be connected with a printed circuit board provided with a control unit including a gate drive unit for supplying a scan signal, a data drive unit for supplying a data signal or a timing control unit for supplying a timing control signal.

The bending region BDA may be provided between the front panel region FPN and the rear panel region BPN. The bending region BDA may be the region that is bendable to make the rear panel region BPN and the front panel region FPN face each other in contact.

Meanwhile, in a state of the substrate FSUB, the light emitting element ED, the thin film transistor TFT for driving the light emitting element ED, and various wires may be formed. Accordingly, the connection wires LE for transmitting the driving signal to the light emitting element ED and the thin film transistor TFT may be also extended from the front panel region FPN to the rear panel region BPN without being cut off.

In this instance, since the bending region BDA is formed to be bendable through a bending process, some of the connection wires LE disposed on the bending region BDA could be damaged during the bending process.

Accordingly, referring to the enlarged plane view of the connection wires LE disposed on the bending region BDA in the embodiment of the present disclosure, the width W2 of the connection wires LE disposed on the bending region BDA may be relatively broader than the width W1 of the connection wires LE disposed on the front panel region FPN and the rear panel region BPN. Here, the connection wires disposed on the bending region BDA may be referred to as the side wires SE.

The bank BNK disposed on the planarization layer P covering the light emitting element ED formed on the substrate FSUB may be formed by extending from the outermost area of the front panel region FPN to a predetermined area of the rear panel region BPN. Except the bank BNK disposed on the front panel region FPN, the area extending from the outermost area of the front panel region FPN to the predetermined area of the rear panel region BPN may be referred to as the side wire protection layer SDP. The side wire protection layer SDP may be formed to cover the exposed surface of the side wires SE disposed on the bending region BDA.

The sealing insulating layer PTL disposed on the bank BNK may extend from the outermost area of the front panel region FPN to the predetermined area of the rear panel region BPN. The sealing insulating layer PTL may cover all the exposed surface of the side wire protection layer SDP disposed on the bending region BDA and the rear panel region BPN.

In the embodiment of the present disclosure, the wires for transmitting the driving signal to the light emitting element ED and the thin film transistor TFT, the planarization layer P and the sealing insulating layer PTL may be formed in a state where the substrate FSUB is flatly folded.

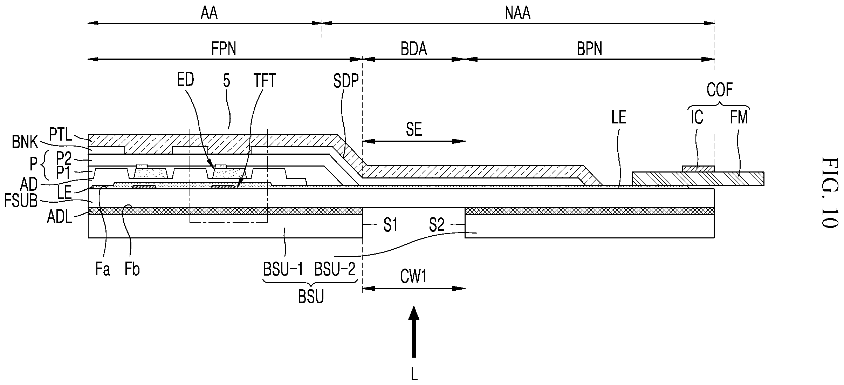

Referring to FIG. 10, some area of the support member BSU disposed in the direction of the second surface Fb of the substrate FSUB may be removed. The support member BSU may be removed by using laser such as LLO (Laser Lift Off). While a mask covers the rear surface of the support member BSU in the rear panel region BPN and the front panel region FPN, which is the portion other than the portion CW1 corresponding to the bending region BDA, Laser L may be radiated only to the area CW1 corresponding to the bending region BDA. In this instance, the laser L may be irradiated to the portion CW 1 corresponding to the bending region BDA to selectively remove only the support member BSU on the portion. Accordingly, the support member BSU may include a first support unit BSU-1 disposed at a position corresponding to the front panel region FPN and a second support unit BSU-2 disposed at a position corresponding to the rear panel region BPN.

The surface of the second surface Fb of the substrate FSUB may be exposed on the portion corresponding to the bending region BDA. One lateral surface S1 of the first support unit BSU-1 and one lateral surface S2 of the second support unit BSU-2 facing the surface S1 of the first support unit B SU-1 may be exposed.

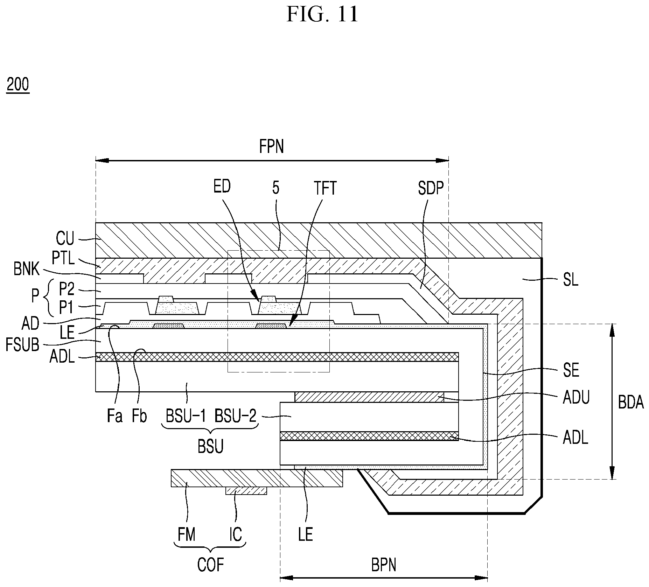

Referring to FIG. 11, the bending region BDA of the substrate FSUB flatly unfolded may be bending to be folded. Then, the substrate FSUB may be folded so that the rear panel region BPN and the front panel region FPN may face each other.

While the portion of the substrate FSUB corresponding to the bending region BDA is folded, one lateral surface S1 of the first support unit BSU-1 and one lateral surface S2 of the second support unit BSU-2 may contact the exposed second surface Fb of the substrate FSUB.

The support member BSU may include the first support unit BSU-1 disposed in the direction of the second surface Fb of the substrate FSUB on the front panel region FPN, and the second support unit BSU-2 disposed in the direction of the second surface Fb of the substrate on the rear panel region BPN.

The second support unit BSU-2 may be secured to the first support unit BSU-1 through the adhesive member ADU to be secured to the rear surface of the front panel region FPN. For example, the adhesive member ADU may include a pressure sensitive adhesive (PSA), an optical clear adhesive (OCA) or a transparent optical clear resin (OCR).

The side wires SE may bend together with the bending region BDA. The adhesive member ADU may include a pressure sensitive adhesive (PSA), an optical clear adhesive (OCA) or a transparent optical clear resin (OCR).

In the embodiment of the present disclosure, a plurality of processes to forming the side wires SE, the side wire protection layer SDP and the sealing insulating layer PTL may be omitted only to realize process optimization.

For example, the display device including a plurality of display modules formed by bonding a plurality of lower substrates and a plurality of upper substrates and aligning the plurality of display modules in horizontal and vertical directions may require side wires for electrically connecting the plurality of lower substrates and the plurality of upper substrates with each other. To form the side wires, there must be provided an edge treating process of treating an edge area of the upper substrate by using a grind wheel, a process of forming the side wires by extending the edge area of the upper substrate toward an edge area of the lower substrate, a process of forming a side protection layer for covering the side wires to protect, and a process of forming a sealing insulating layer disposed on the side protection layer.

In the embodiment of the present disclosure, the connection wire LE extending from the front panel region FPN of the substrate FSUB to the rear panel BPN may be formed through the bending region BDA. Here, the portion of the connection wires LE, which is disposed on the bending region BDA may configured as the side wires SE. Accordingly, a separate process of forming the side wires SE may be omitted. In addition, the bank BNK may extend from the outermost point of the front panel region FPN to the rear panel region BPN to be formed as the side wire protection layer SDP. In one embodiment, the side wire protection layer SDP may cover at least the side wires SE in the bending region BDA, and disposed to extend from the front panel region FPN of the substrate FSUB to the rear panel region BPN. Accordingly, another separate process of forming the side wire protection layer SDP may be omitted. In addition, a separate process of forming the sealing insulating layer PTL on the bending region BDA may be omitted by extending the sealing insulating layer PTL from the outermost point of the front panel region FPN to a predetermined area of the rear panel region BDA.

Next, the cover member CU may be disposed on the sealing insulating layer PTL. The cover member CU may protect the light emitting element ED from external shock. The cover member CU may be made of glass or plastic but the embodiment is not limited thereto. For example, the cover member CU may further include a functional optical film. The cover member CU may be adhered to the sealing insulating layer PTL via an optical transparent adhesive but the embodiment is not limited thereto.

Continuously, the side sealing member SL may be formed on a lateral surface of the substrate FSUB to form the display device 200. The side sealing member SL may protect the display device and the side wires SE and also prevent moisture from penetrating from the lateral surface. The outer surface of the side sealing member SL may be disposed on the same plane with the outermost surface of the cover member CU to form alignment. In one embodiment, a lateral surface of the side sealing member SL is flush with a lateral surface of the cover member CU.

If performing a separate process of forming the side wires for electrically connecting the upper and lower substrates with each other after bonding the upper substrate on which the light emitting element is disposed and the lower substrate on which the chip-in-film is disposed to each other, a process defect rate might increase.

If fixedly bonding the upper and lower substrates to each other after forming the upper substrate, on which the light emitting element is disposed, and the lower substrate, on which the chip-in-film is disposed, in separate processes, respectively, a defect might occur during the process of realizing a curved display device that is bendable at the outermost portions of both sides. In an embodiment, when the outermost portions of the bonded upper and lower substrates are bent, the side wires electrically connecting the upper and the lower substrates might be disconnected in the process of being bent and this might result in a defect.

In contrast, according to the embodiment of the present disclosure, the light emitting element ED, the thin transistor TFT and the chip-on-film COF, on which the integrated circuit chip IC is mounted, etc. are formed on one substrate FSUB, it may be possible to omit the plurality of processes, thereby optimizing the processes and reducing costs.

In addition, according to the embodiment of the present disclosure, the connection wires LE and the side wires SE may extend from the front panel region FPN to the rear panel region BPN without disconnection, thereby preventing the disconnection of the side wires SE and improving product reliability.

The embodiment of the present disclosure may increase the region having the support member removed therefrom, thereby realizing a thinner display device.

Hereinafter, another embodiment of the present disclosure will be described, referring to the accompanying drawings.

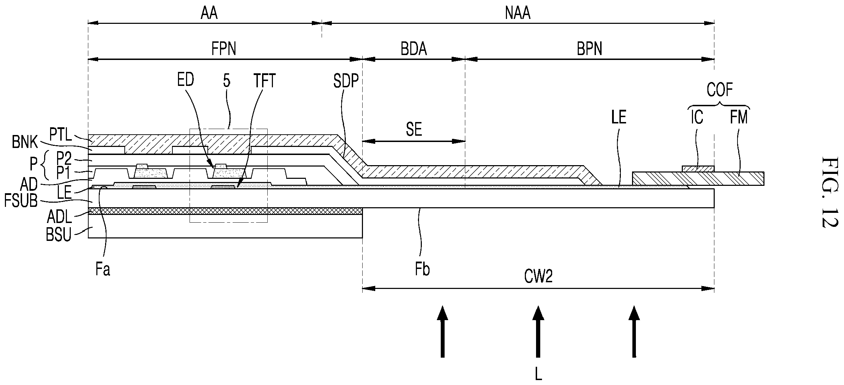

FIGS. 12 to 14 are views showing a method of manufacturing a display device according to another embodiment of the present disclosure.

Referring to FIG. 12, a predetermined portion of the support member BSU disposed in the direction of the second surface Fb of the substrate FSUB on which the light emitting element ED, the thin film transistor TFT and the chip-on-film including the circuit film FM on which the integrated circuit chip IC is mounted may be removed. The support member BSU may be removed by using the laser L such as Laser Lift Off (LLO).

Here, the laser L may be irradiated to the portion CW2 corresponding to the bending region BDA and the rear panel region BPN, to selectively remove the support member BSU of the corresponding portion.

Accordingly, the support member BSU may remain only the portion corresponding to the front panel region FPN.

The portions corresponding to the bending region BDA and the rear panel region BPN may be removed together with the coupling member ADL to expose the surface of the second surface Fb of the substrate FSUB. Alternatively, the support member BSU and one lateral surface of the coupling member ADL may be exposed at a surface between the front panel region FPN and the bending region BDA.

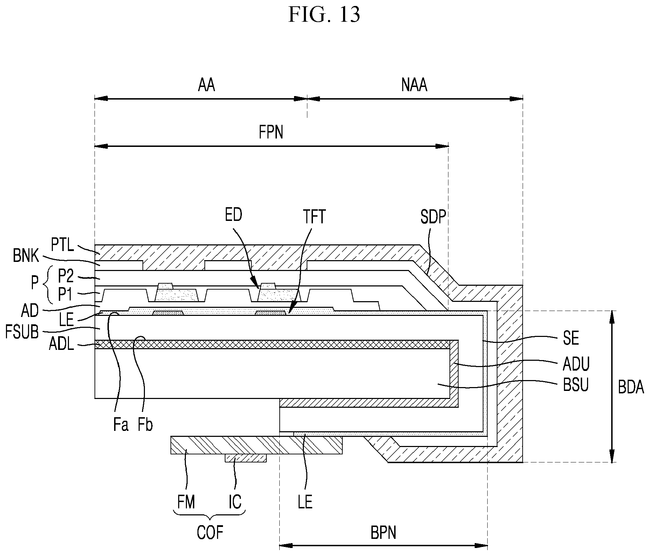

Referring to FIG. 13, the adhesive member ADU may be disposed on the second surface FB of the substrate FSUB, which is exposed to the bending region BDA and the rear panel region BPN. Hence, the bending region BDA of the substrate FSUB that is unfolded flatly may bend to be folded. If then, the substrate FSUB may be in a folded state in which the rear panel region BPN and the front panel region FPN face to each other. For example, the adhesive member ADU may include a pressure sensitive adhesive PSA, an optical clear adhesive OCA or an optical clear resin OCR.

While the portion of the substrate FSUB corresponding to the bending region BDA is bending, one surface of the support member BSU may become into contact with the adhesive member ADU. The rear panel region BPN of the substrate FSUB may be secured to the rear surface of the support member BSU through the adhesive member ADU. As only the substrate FSUB is adhered with the support member BSU interposed therebetween, the display device may have a relatively thin thickness.

The side wires SE may bend together with the bending region, as the bending region BDA is bending. Here, the width of the side wires SE may be formed to be relatively broader than the width of the connection wires LE disposed on the front panel region FPN and the rear panel region BPN so that damage due to a manipulation of bending the side wires along the bending region BDA might be prevented.

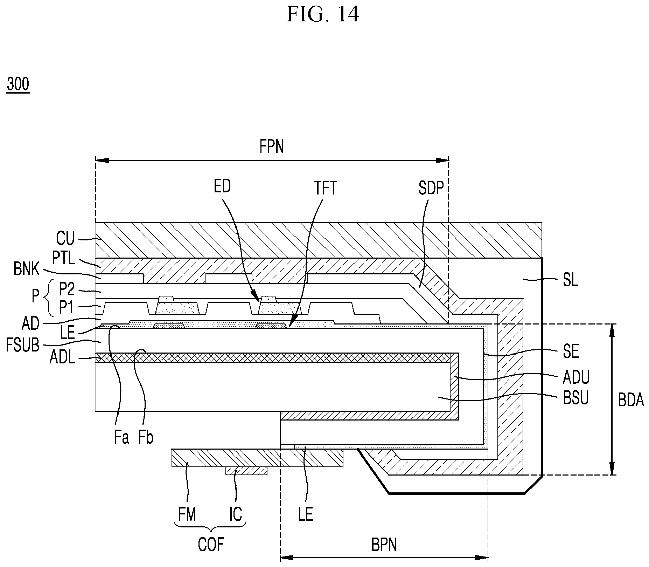

Referring to FIG. 14, the cover member CU may be disposed on the sealing insulating layer PTL. The cover member CU may protect the light emitting element ED from external shock. The cover member CU may include glass or plastic but the embodiment is not limited thereto. For example, the cover member CU may further include a functional optical film such as an anti-scattering film. The cover member CU may be adhered to the sealing insulating layer PTL via an optical transparent adhesive but the embodiment is not limited thereto.

Hence, the display device 300 may be formed by forming the side sealing member SL. The side sealing member SL may protect the side wires SE of the display device and prevent moisture from penetrating from the lateral surface. The outer surface of the side sealing member SP may be disposed on the same plane with the outermost surface of the cover member CU to form alignment.

According to the embodiment of the present disclosure, the single structure of the substrate FSUB may be attached with the support members BSU interposed therebetween so that the overall thickness of the display device can become slim.

In addition, since the substrate FSUB including a lightweight material such as polyimide is applied to the display device, the embodiment of the present disclosure may have an advantage of realizing lightweight product.

According to an embodiment of the present disclosure, a structure for dissipating heat from the display device to the outside may be introduced, which will be described referring to the accompanying drawings.

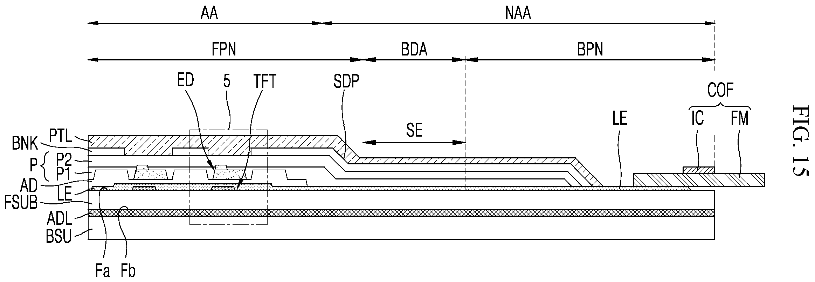

FIGS. 15 to 18 are views showing a method of manufacturing a display device 400 according to another embodiment of the present disclosure. Here, the step of forming the light emitting element ED, the thin film transistor TFT and the chip-on-film COF including the circuit film FM, on which the integrated circuit chip IC is mounted, on the substrate FSUB shown in FIGS. 8 and 9 may be the same as a process shown in this embodiment. Accordingly, repeated description will be omitted and a different feature will be described.

In addition, the light emitting element ED and the thin film transistor TFT of this embodiment is the same as the light emitting element ED and the thin film transistor TFT of the embodiment shown in FIG. 5, of which detailed description will be omitted accordingly. In an embodiment, the light emitting element ED may be a vertical-type micro LED.

Referring to FIG. 15, the substrate FSUB on which the light emitting element ED, the thin film transistor TFT, and the chip-on-film having the circuit film on which the integrated circuit chip IC is mounted are formed may be prepared.

The display device 400 according to this embodiment of the present disclosure is differently characterized in that the light emitting element ED is formed on the substrate FSUB and the planarization layer P extends to the rear panel region BPN. Specifically, the structure configured of the first planarization layer P1 and the second planarization layer P2may cover the bending region BDA from the front panel region FPN and extend to a predetermined area of the rear panel region BPN.

Next, the side wire protection layer SDP disposed on the planarization layer P may also extend to a predetermined area of rear panel region BPN from the outermost portion of the front panel region FPN. Accordingly, the side wire protection layer SDP may be disposed on the planarization layer P extended to a predetermined area of the rear panel region BPN.

Hence, the sealing insulating layer PTL disposed on the bank BNK formed on the front panel region FPN may be extended to some area of the rear panel region BPN from the outermost portion of the front panel region FPN. The sealing insulating layer PTL may cover all the exposed surface of the side wire protection layer SDP disposed on the bending region BDA and the rear panel region BPN. The sealing insulating layer PTL may be disposed to extend from the front panel region FPN of the substrate FSUB to the rear panel region BPN of the substrate FSUB, and cover the side wires SE and the sealing insulating layer SDP.

Meanwhile, the support member BSU disposed on the second surface Fb of the substrate FSUB may include a metal material to dissipate the heat generated from the inside of the display device to the outside. In an embodiment, the support member BSU may be made of a material capable of dissipating heat easily such as aluminum Al.

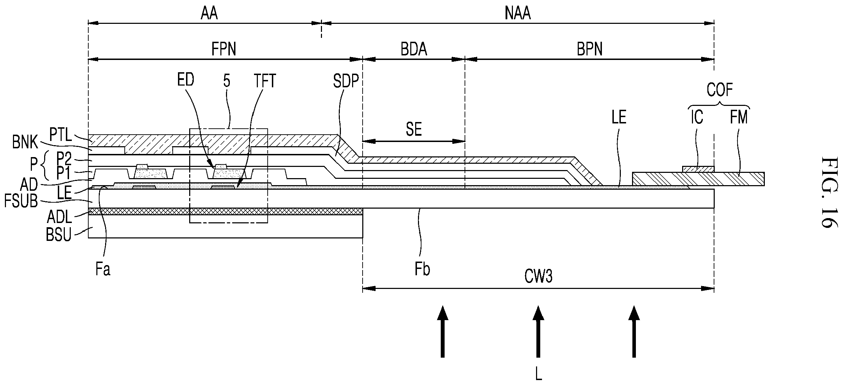

Referring to FIG. 16, a predetermined area of the support member BSU disposed in the direction of the second surface Fb of the substrate FSUB may be removed. The support member BSU may be removed by using the laser L such as LLO (Laser Lift Off).

Here, the laser L may be irradiated to a portion CW3 corresponding to the bending region BDA to selectively remove only the support member BSU on the portion.

Accordingly, the support member BSU may remain on a portion corresponding to the front panel region FPN.

The coupling member ADL together with the support member may be removed from the portion corresponding to the bending region BDA and the rear panel region BPN, to expose a surface of the second surface Fb of the substrate FSUB. One surface of the support member BSU and one surface of the coupling member ADL may be exposed to a boundary surface between the front panel region FPN and the bending region BDA.

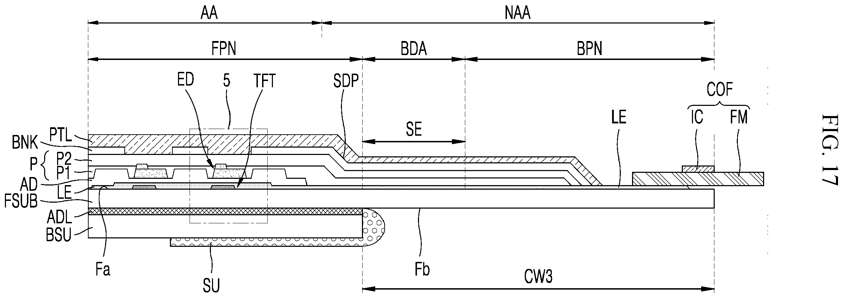

Referring to FIG. 17, a reinforcing member SU may be disposed on the support member BSU disposed on a portion corresponding to the front panel region FPN. The reinforcing member SU may include mandrel. The reinforcing member SU may be fixedly attached to a position corresponding to one lateral surface and a rear surface of the support member BSU.

In an embodiment, an adhesive member may be disposed on the second surface Fb of the substrate FSUB exposed to the bending region BDA and the rear panel region BPN. For example, the adhesive material may a pressure sensitive adhesive (PSA), an optical clear adhesive (OCA) or a transparent optical clear resin (OCR).

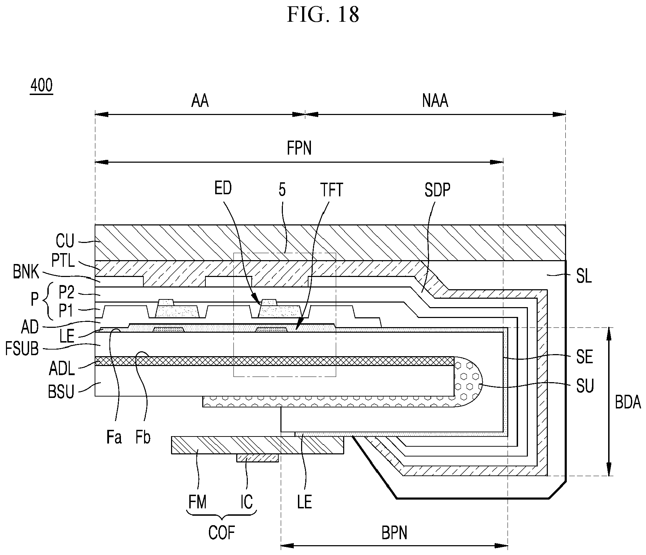

Referring to FIG. 18, the bending region BDA of the substrate is in a state of being unfolded flatly. Then, the substrate FSUB may be folded so that the rear panel region BPN and the front panel region FPN may face each other.

Here, as it is getting folded, the portion of the substrate FSUB corresponding to the bending region BDA may become securely into contact with one lateral surface of the reinforcing member SU. Accordingly, the rear panel region BPN of the substrate FSUB may be secured to a rear surface of the support member BSU. As the reinforcing member SU is disposed corresponding to the bending region BDA, the rigidity of the substrate FSUB may be improved.

The side wires SE may be bent together along the bending region BDA. The width of the side wires SE may be formed to be relatively broader than the width of the connection wires LE disposed on the front panel region FPN and the rear panel region BPN so that damage due to a manipulation of bending the side wires along the bending region BDA might be prevented.

Next, the cover member CU may be disposed on the sealing insulating layer PTL. The cover member CU may protect the light emitting element ED from external shock. The cover member CU may be made of glass or plastic but the embodiment is not limited thereto. For example, the cover member CU may further include a functional optical film. The cover member CU may be adhered to the sealing insulating layer PTL via an optical transparent adhesive but the embodiment is not limited thereto.

Continuously, the side sealing member SL may be formed on a lateral surface of the substrate FSUB to form the display device 200. The side sealing member SL may protect the display device and the side wires SE and also prevent moisture from penetrating from the lateral surface. The outer surface of the side sealing member SL may be disposed on the same plane with the outermost surface of the cover member CU to form alignment. For example, the side sealing member SL may include a resin.

The display device 400 according to the embodiment of the present disclosure may include the support member made of a metal material, thereby easily dissipating the heat generated from the inside of the display device to the outside.

The planarization layer disposed on the light emitting element, the side wire protection layer, and the sealing insulating layer may be extended from the outermost portion of the front panel region to a predetermined region, thereby preventing the damage of the side wires disposed on the lateral surface of the display device.

In addition, the reinforcing member may be disposed on the rear surface of the substrate, thereby improving the rigidity of the substrate.

Each of the plurality of display devices 100-1, 100-2, 100-3,..100-M and 100-N according to other embodiment of the present disclosure may include a plurality of bending regions. The plurality of bending regions may be realized by selecting an area for a laser lift off process and performing the laser lift off process, which will be described as follow referring to the drawing.

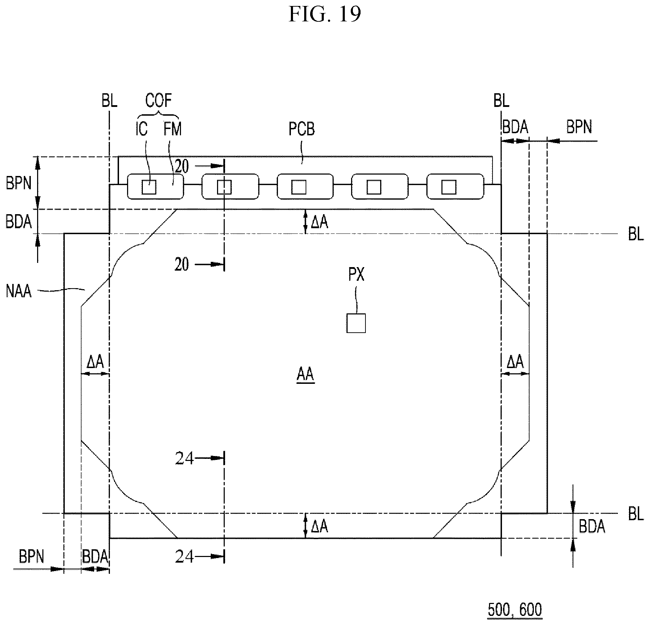

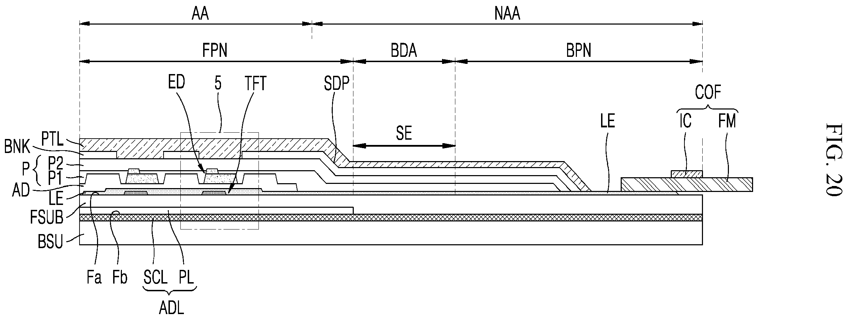

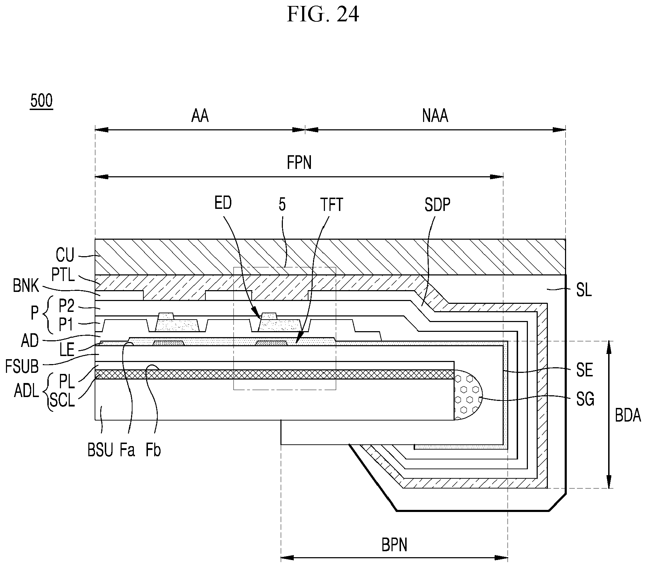

FIG. 19 is a plane view showing that a display device according to a still further embodiment of the present disclosure is unfolded. FIGS. 20 to 24 are views to describe a manufacturing method of a display device according to a still further embodiment of the present disclosure. Here, FIGS. 20 to 23 are sectional views along a line 20-20 of FIG. 19. FIG. 24 is a sectional view along a line 24-24 of FIG. 19 according to an embodiment of the present disclosure.

The step of forming the chip-on film including the circuit film on which the light emitting element ED, the thin film transistor TFT and the integrated circuit chip IC are mounted is the same as the step shown in FIGS. 5, 8, and 9, thereby omitting the repeated description. Hereinafter, different technical features will be described.

Referring to FIGS. 19 and 20, a display device 500 according to this embodiment may include a display area AA in which a plurality of pixels are disposed and a non-display area NAA surrounding the display area AA. Each of the plurality of pixels PX may include a plurality of sub-pixels. The plurality of sub-pixels may include light emitting elements configured to emit red light R, green light G and blue light B, respectively. However, the embodiment is not limited thereto and the light emitting element may further include a white light emitting element emitting white light.

A substrate FSUB may include a front panel region FPN, a bending region BDA and a rear panel region BPN. The substrate FSUB may be configured as a one sheet substrate. The front panel region FPN may include the display area AA. The bending region BDA may be bendable so that the rear panel region BPN and the front panel region FPN can face each other.

The display device 500 according to this embodiment may have a bending line BL disposed on four lateral surfaces of the display area AA to designate boundaries between the front panel region FPN and the bending region BDA. For example, the bending line BL may be disposed on an upper surface, a lower surface, a left surface and right surface of the display area AA. As the display device 500 is bending along the bending line BL, the bending region BDA may be set. In other words, the bending region BDA may be disposed on an upper surface, a lower surface, a left surface and a right surface of the display area AA. The display device 500 may include two or more COF's on the portion of the rear panel region BPN of the substrate FSUB. The substrate FSUB may include multiple bending regions BDA and multiple rear panel regions BPN, where each bending region BDA is disposed between the front panel region FPN and a respective rear panel region BPN of the substrate FSUB. The substrate FSUB is bent such that the second surface Fb of each rear panel region BPN faces the second surface Fb of the front panel region FPN of the substrate FSUB.

The chip-on film COF including the circuit film FM, on which the integrated circuit chip IC is mounted, and the printed circuit board PCB may be disposed in at least one area of the display device.

Referring to FIG. 20 again, the support member BSU may be coupled to the second surface Fb of the substrate FSUB, on which the light emitting element ED, the thin film transistor TFT and the chip-on film COF are formed on the coupling member ADL. As one example, the light emitting element ED may be disposed on the front panel region FPN.

As another example, the light emitting element ED may extend to a one area of the bending area BPN disposed between the front panel region FPN and the rear panel region BPN. When the light emitting element ED is disposed by extending to the one area of the bending region BPN, the display area AA occupied in the display device may be increased as much as the area (ΔA, see FIG. 19 ) extended to the one area of the bending region BPN. The extended area to the one area of the bending region BPN, on which the light emitting elements ED are disposed, may be at least one of the upper surface, the lower surface, the left surface and the right surface of the display area AA.

The display device according to this embodiment is characterized in that the coupling member ADL is a multilayer structure including a sacrificial layer SCL and a protection layer PL, which is different from the other embodiments.

The sacrificial layer SCL may include the front panel region FPN, the bending region BDA and the rear panel region BPN and may be disposed on a whole surface of the support member BDA. As one example, the sacrificial layer SCL may include an amorphous silicon layer.

The protection layer PL may be disposed on the sacrificial layer SCL and extend to a boundary surface of the bending region BDA from the front panel region FPN. The protection layer PL may be disposed in an area corresponding to the area on which the thin film transistor TFT is disposed. The protection layer PL may prevent the thin film transistor TFT from being damaged by laser during the subsequent laser lift-off process LLO. To this end, the protection layer PL may include a material capable of forming strong coupling energy with the material of the sacrificial layer SCL. For example, the protection layer may include a silicon oxide SiO2.

The support member BSU disposed on the second surface Fb of the substrate FSUB may include glass or plastic, for example.

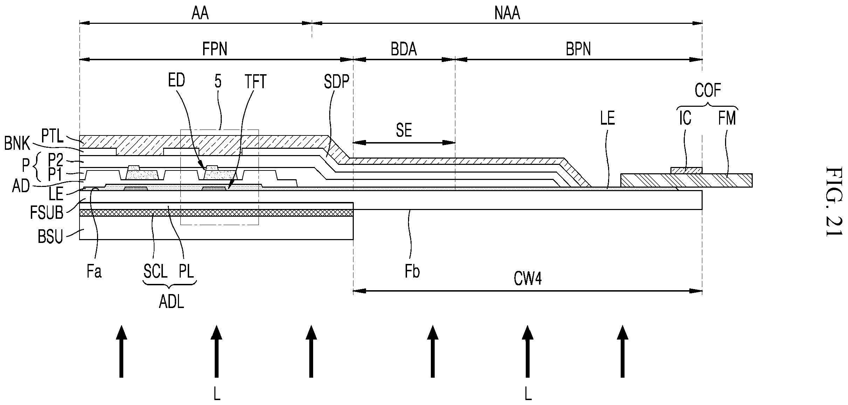

Referring to FIG. 21, the support member BSU may be partially removed. The support member BSU may be removed by the laser lift-off process LLO using laser. The multilayer structure including the sacrificial layer SCL and the protection layer PL may be disposed in the area of the front panel region FPN where the thin film transistor TFT is disposed. The unilayer structure including the sacrificial layer SCL may be disposed in the area of the support member BSU corresponding to the bending region BDA and the rear panel region BPN.

The laser lift-off process LLO may be performed on a whole surface of the substrate FSUB. The laser lift-off process LLO may transfer laser to the sacrificial layer SCL from a rear surface of the support member BSU. Here, the area where the multilayer structure including the sacrificial layer SCL and the protection layer PL is disposed may have the strong coupling energy between the protection layer PL and the sacrificial layer SCL. Accordingly, the thin film transistor TFT may be prevented from being damaged by the laser L penetrating the area where the thin film transistor TFT is disposed. In addition, since the strong coupling energy is formed between the protection layer PL and the sacrificial layer SCL, the sacrificial layer SCL may remain without being removed.

The unilayer structure of the sacrificial layer SCL may be disposed in the area CW4 corresponding to the bending region BDA and the rear panel region BPN. Accordingly, the intermolecular binding force of the sacrificial layer SCL may be released at the area CW4 corresponding to the bending region BDA and the rear panel region BPN, and then the sacrificial layer SCL may be removed from the substrate FSUB. While removing the sacrificial layer SCL, the support member BSU in the area corresponding to the sacrificial layer SCL may also be removed. After that, the support member BSU may remain only in the area corresponding to the front panel region FPN.

The coupling member ADL may be also removed from the area corresponding to the bending region BDA and the rear panel region BPN, to expose the second surface Fb of the substrate FSUB. Also, lateral surfaces of sacrificial layer SCL and the support member BSU may be exposed at the boundary surface between the front panel region FPN and the bending region BDA.

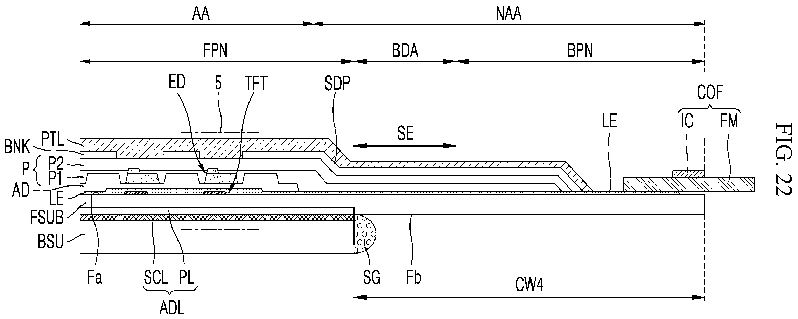

Referring to FIG. 22, a sealing material SG may be disposed the exposed lateral surfaces of the support member BSU and the sacrificial layer SCL. The sealing material SG may serve as a buffer for buffering damage to the substrate FSUB in the process of bending and folding the bending region BDA of the flatly unfolded substrate FSUB. The sealing material SG may be disposed to surround four lateral surfaces of the display area AA, viewed from the plane view of FIG. 19.

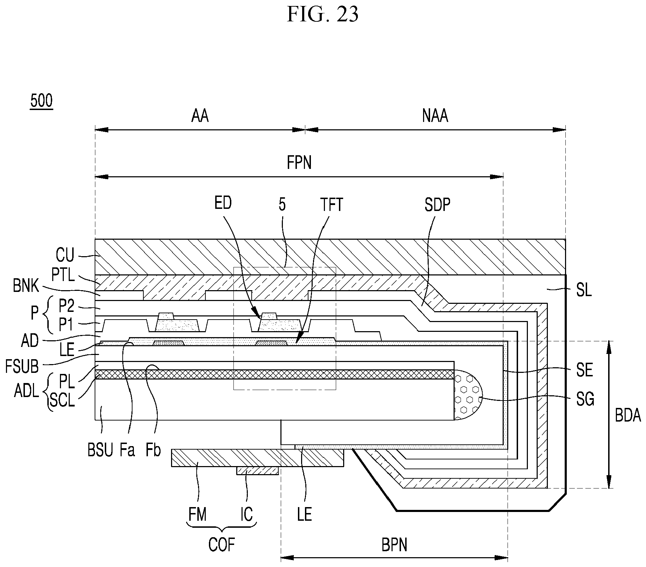

Referring to FIG. 23, the bending region BDA of the substrate FSUB flatly unfolded may be bending to be folded. Then, the substrate FSUB may be folded so that the rear panel region BPN and the front panel region FPN may face each other. The chip-on film COF including the circuit film FM on which the integrated circuit IC is mounted may be disposed on the rear panel region BPN.

Referring to FIG. 24, the area of the display device 500 in which the chip-on film COF is not disposed may be folded so that the rear panel region BPN of the substrate FSUB can face the rear surface of the front panel region FPN.

Meanwhile, only the support member of the area desired to be eliminated may be selectively removed by selectively performing the laser lift-off process, which will be described referring to the accompanying drawings.

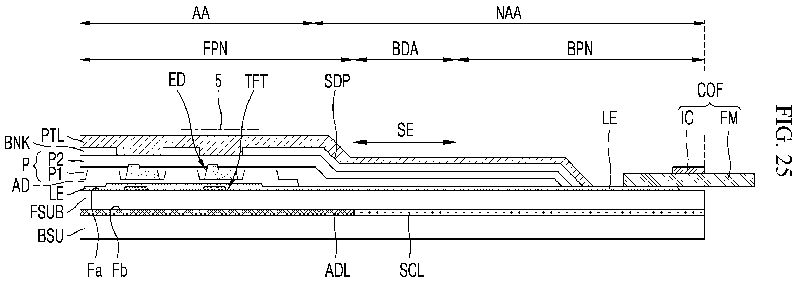

FIGS. 25 to 28 are views to describe a manufacturing method of a display device according to a still further embodiment of the present disclosure. Here, the step of forming the light emitting element ED, the thin film transistor TFT and the chip-on-film COF including the circuit film FM, on which the integrated circuit chip IC is mounted, on the substrate FSUB shown in FIGS. 5, 8, and 9 may be the same as a process shown in this embodiment. Accordingly, repeated description will be omitted and a different feature will be described.

Referring to FIG. 25, the support member BSU may be coupled to the second surface Fb of the substrate FSUB, on which the chip-on film COF including the circuit film FM on which the light emitting element ED, the thin film transistor TFT and the integrated circuit chip IC are mounted are formed, via the coupling member ADL. The display device according to this embodiment is characterized in that the sacrificial layer SCL is disposed only in the area where the laser lift-off process is performed, which is different from the other embodiments.

As one example, the light emitting element ED may be disposed on the front panel region FPN. As another example, the light emitting element ED may be disposed even in an area extended to a one area of the bending region BPN between the front panel region FPN and the rear panel region BPN. In this instance, the light emitting element ED may be disposed even in the area extended to some area of the bending region BPN, thereby increasing the entire area of the display area AA occupied in the display device.

The sacrificial layer SCL may be disposed on the bending region BDA and the rear panel region BPN, except the front panel region FPN. As one example, the sacrificial layer SCL may include an amorphous silicon layer.

The coupling member ADL may extend to a boundary surface of the bending region BDA from the front panel region FPN. The coupling member ADL may be an adhesive or a double-sided tape, for example, but the embodiment is not limited thereto.

The support member BSU disposed on the second surface Fb of the substrate FSUB may include glass or plastic, for example.

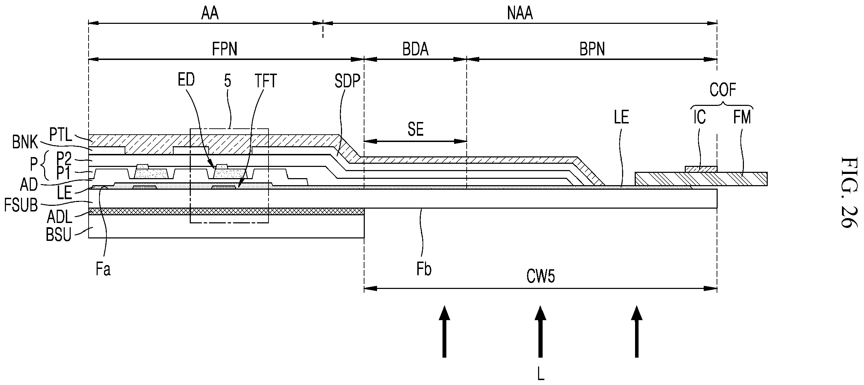

Referring to FIG. 26, the support member BSU may be partially removed. The area of the support member BSU may be removed by performing the laser lift-off process LLO using laser. The laser may be transferred to the sacrificial layer SCL (see FIG. 25) from the rear surface of the support member BSU. Then, the molecular binding energy of the sacrificial layer SCL (see FIG. 25) may be released and the sacrificial layer may be removed from the substrate FSUB. At this time, the support member BSU may be also removed together.

Since the sacrificial layer SCL is disposed in the area CW5 corresponding to the bending region BDA and the rear panel region BPN, the area where the laser lift-off process LLO will be performed may be designated.

The support member BSU may remain only in the area corresponding to the front panel region FPN. The second surface Fb of the substrate FSUB may be exposed in the area corresponding to the bending region BDA and the rear panel region BPN by removing the coupling member ADL together with the support member. In addition, the lateral surfaces of the support member BSU and the coupling member ADL may be exposed on the boundary surface of the bending region BDA and the front panel region FPN.

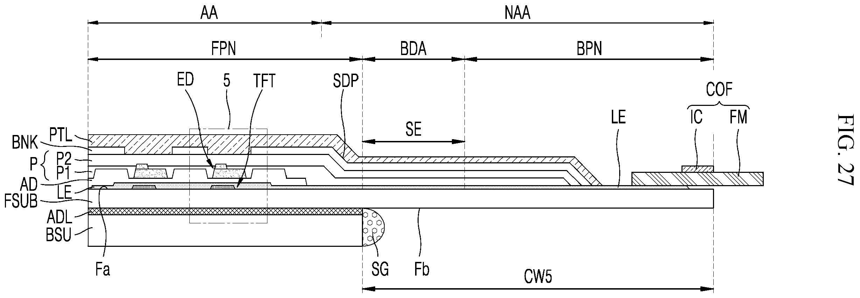

Referring to FIG. 27, the sealing material SG may be disposed on the exposed lateral surfaces of the support member BSU and the coupling member ADL. The sealing material SH may be disposed to surround four lateral surfaces of the display area AA, viewed from the plane of the FIG. 19.

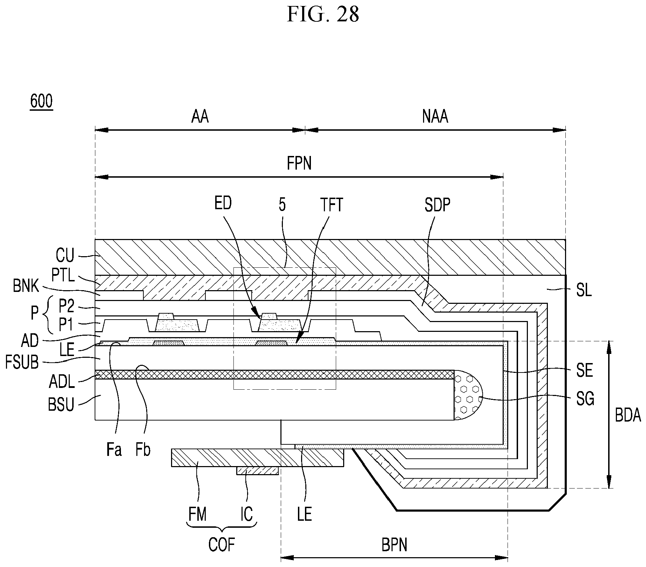

Referring to FIG. 28, the flatly spread bending area BDA of the substrate FSUB may be bent and folded. Then, the substrate FSUB may be folded so that the rear panel region BPN can face the rear surface of the front panel region FPN. The chip-on film COF including the circuit film FM on which the integrated circuit chip IC is mounted may be disposed on the rear panel region BPN. The other area of the display device 600 where the chip-on film COF is not disposed may be folded so that the rear panel region BPN of the substrate FSUB can face the rear surface of the front panel region FPN.

The display devices 500 and 600 including the plurality of bending regions according to this embodiment may be operated as separate display devices, which will be described referring to the accompanying drawings.

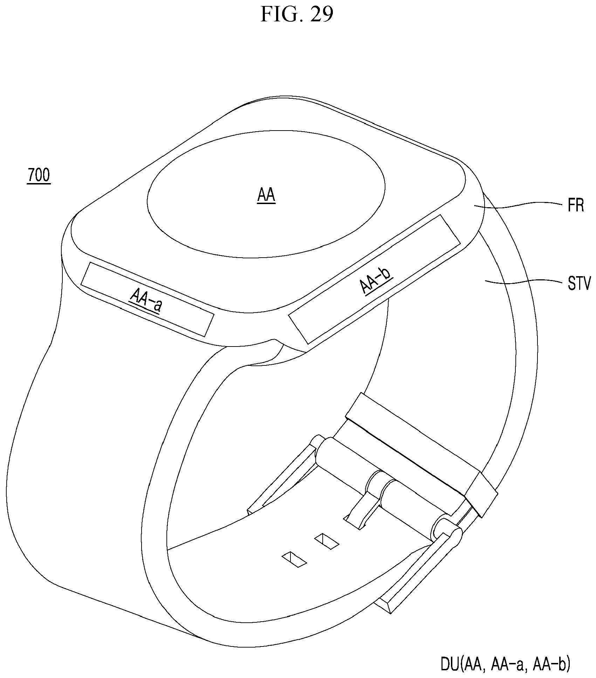

FIG. 29 is a view showing a wearable device including a display device according to a still further embodiment of the present disclosure.

Referring to FIG. 29, the wearable device 700 may include a display unit DU, a frame FR and a strap unit STU. As one example, the wearable device 700 may include a smart watch. The frame FR may be a structure assembled to define an exterior design of the wearable device 700. The display unit DU may be disposed in a space defined by the frame FR. The display unit DU may include a display area AA and a plurality of sub-display areas AA-a and AA-b. The display area AA may be visible on a front surface of the wearable device 700. The plurality of sub-display areas AA-a and AA-b may be visible on a front surface or lateral surfaces of the wearable device 700. The strap unit STU may facilitate the wearing and fixing of the wearable device 700. The strap unit STU may be coupled to or physically connected the display unit.

The display unit DU may include the display area AA of the display device 500 and 600 including the plurality of bending regions shown in FIG. 19. In this instance, the light emitting element ED may be extendedly disposed on even the one area of the bending region BPN between the front panel region FPN and the rear panel region BPN. When the light emitting element ED is disposed extendedly disposed even in the one area of the bending region BPN, the area of the display are AA occupied in the display device may be increased as much as the extended area (ΔA, see FIG. 19) extended to the one area of the bending region BPN. The area extended to the one area of the bending region BPN may be the plurality of sub-display areas AA-a and AA-b.

The display area AA and the plurality of sub-display areas AA-a and AA-b of the display unit DU of the wearable device 700 may transmit different images to the outside. In addition, the plurality of sub-display areas AA-a and AA-b may transmit different images to the outside.

A display device according to an aspect of the present disclosure will be described as follows.

The display device according to the aspect of the present disclosure may include a substrate comprising a front panel region, a rear panel region and a bending region disposed between the front panel region and the rear panel region; a display region located in the front panel region, a plurality of light emitting elements being disposed on the display region; an integrated circuit chip disposed on the rear panel region; and connection wires extending from the front panel region to the rear panel region of the substrate through the bending region. The rear panel region of the substrate may be secured to a lower portion of the substrate that corresponds to the front panel region.

A tiling display device according to another aspect of the present disclosure may include a plurality of display devices. The plurality of display devices may be disposed to position bending regions of substrates adjacent to each other. One or more (e.g., each) of the display devices may be configured as a display device according to one or more aspects and/or embodiments of the present disclosure as described herein.

The substrate may include a transparent insulating material having flexibility.

The connection wires may include side wires disposed on the bending region of the substrate, and the width of the side wires may be broader than the width of the connection wires disposed on the front panel region and the rear panel region.

The substrate may include a first surface and a second surface that is a rear surface of the first surface, and the substrate may further include a support member supporting the substrate in direction of the second surface of the substrate.

The support member may include a first support unit disposed on the front panel region in a direction of the second surface of the substrate; and a second support unit disposed on the rear panel region in a direction of the second surface of the substrate, spaced apart from the first support unit.

The display device may further include an adhesive member securing the first support unit and the second support unit. The adhesive member may include a transparent optical adhesive or a transparent optical resin.

The second surface of the substrate corresponding to the bending region may be exposed, and a lateral surface of the first support unit and a lateral surface of the second support unit may become in contact with the exposed second surface of the substrate.

The support member may be disposed on the front panel region in a direction of a second surface of the substrate, and the second surface of the substrate corresponding to the bending region and the rear panel region may be secured corresponding to a lateral surface and a rear surface of the support member.

The display device may further include a reinforcing member attached to a position corresponding to the lateral surface and the rear surface of the support member. The reinforcing member may become in contact with the second surface of the substrate corresponding to the bending region and the rear panel region.

The support member may include a metal material comprising aluminum Al, and the reinforcing member may include a material harder than the substrate.

The substrate may include a planarization layer covering the light emitting element; a side wire protection layer disposed on the planarization layer and covering the side wires by extending from an outermost portion of the front panel region to the rear panel region; a sealing insulating layer disposed on the side wire protection layer and covering the side wire protection layer by extending from the front panel region to the rear panel region; a cover member disposed on the sealing insulating layer on at least the front panel region; and a side sealing member covering lateral surfaces of the substrate.

An end of the side sealing member may be disposed on the same plane with an outermost lateral surface of the cover member to form alignment.

The side sealing member may include a resin.

A substrate including a front panel region, a rear panel region and a bending region disposed between the front panel region and the rear panel region, the substrate provided in a separate one among the plurality of display devices may be one substrate.

The light emitting element may include a nitride semiconductor structure comprising a first semiconductor layer, an active layer disposed on the first semiconductor layer, and a second semiconductor layer; a passivation pattern disposed outside the nitride semiconductor structure; a first electrode linked to the first semiconductor layer; and a micro LED comprising a second electrode linked to the second semiconductor layer.

A display device according to another aspect of the present disclosure may comprise: a substrate comprising a front panel region, a rear panel region, and a bending region between the front panel region and the rear panel region; a thin film transistor on the substrate, the thin film transistor including an active layer, a gate insulating layer, a gate electrode, a source electrode, and a drain electrode; an interlayer insulating film on the gate electrode of the thin film transistor; a connection electrode on the interlayer insulating film, the connection electrode electrically connected to the thin film transistor; an adhesive layer on the connection electrode, the adhesive layer including adhesive material; a planarization layer on the adhesive layer, wherein the adhesive layer and the planarization layer is formed with a contact hole exposing at least a portion of the connection electrode; at least one micro light emitting diode (micro LED) disposed on at least a portion of the adhesive layer, the micro LED including a semiconductor layer and another semiconductor layer; a wire electrode electrically connecting the semiconductor layer of the micro LED and the connection electrode through the contact hole.

The display device may further comprise a passivation layer covering a side surface of the semiconductor layer or a side surface of the another semiconductor layer.

The planarization layer may cover a side surface of the passivation layer.

The planarization layer may include a first planarization layer and a second planarization layer on the first planarization layer.

The second planarization layer may be formed with a second contact hole exposing at least a portion of an electrode on the semiconductor layer, wherein the wire electrode may be electrically connected to the electrode through the contact hole, and may electrically connect the electrode to the connection electrode.

The second planarization layer may cover a side surface of the wire electrode and a side surface of the electrode.

The display device may further comprise a bank on the planarization layer, wherein the bank may fill at least a portion of the contact hole.

The bank may include a black material.

The bank may extend to cover at least a portion of the front panel region, a rear panel region, and the bending region.

The display device may further comprise a sealing insulation layer covering the bank, the planarization layer, and the wire electrode.

The display device may further comprise a reflection layer disposed below the micro LED, the reflection layer including a material that is configured to reflect light emitted from the micro LED.

The reflection layer may be disposed below the adhesive layer.

The interlayer insulating film may include organic material.

The substrate may be a flexible substrate.

The display device may further comprise: a first connection wire on the front panel region of the substrate, the first connection wires electrically connected to the micro LED; a side wire extending from the first connection wire on the bending region of the substrate, wherein a width of the side wire may be wider than a width of the first connection wire or a width of a second connection wire; and the second connection wire extending from the side wire on the rear panel region of the substrate, the second connection wire electrically connected to an integrated circuit chip.

A tiling display device according to another aspect of the present disclosure may comprise: a set of display devices, the set of display devices including the display device according to one or more aspects and/or embodiments of the present disclosure described herein, wherein each display device may be electrically connected to an adjacent display device, wherein the bending region of the display device according to one or more aspects and/or embodiments of the present disclosure described herein is adjacent to another bending region of a substrate of another display device.

The substrate may be a single substrate formed of a transparent insulating material.

A display device according to another aspect may comprise: a substrate comprising a front panel region, a rear panel region, and a bending region between the front panel region and the rear panel region; one or more thin film transistors; a first insulating layer on the adhesive layer; a connection electrode on the first insulating layer, the connection electrode electrically connected to the one or more thin film transistors; at least one micro light emitting diode (micro LED) disposed on at least a portion of the adhesive layer, the micro LED including a semiconductor layer and another semiconductor layer; a second insulating layer on the first insulating layer, wherein the second insulating layer is formed with a contact hole exposing at least a portion of the connection electrode; a wire electrode electrically connecting the semiconductor layer of the micro LED and the connection electrode through the contact hole; and a bank on the second insulating layer, wherein the bank fills at least a portion of the contact hole, wherein the bank includes a black material.

The substrate may include a display area for emitting light, wherein the display area may be shaped as a circle.

The substrate may further include one or more sub-display areas.

Although the embodiments of the present disclosure have been described in more detail with reference to the accompanying drawings, the present disclosure is not necessarily limited to these embodiments, and may be modified in a various manner within the scope of the present disclosure. Accordingly, the embodiments as disclosed in the present disclosure are intended to describe rather than limit the present disclosure, and the scope of the present disclosure is not limited by these embodiments. Therefore, it should be understood that the embodiments described above are not restrictive but illustrative in all respects.

## Claims

1. A display device (100, 200, 300, 400, 500, 600) comprising:
a substrate (FSUB) comprising a front panel region (FPN), a rear panel region (BPN), and a bending region (BDA) between the front panel region (FPN) and the rear panel region (BPN);
a thin film transistor (TFT) on the substrate (FSUB), the thin film transistor (TFT) including an active layer (ACT), a gate insulating layer (GI), a gate electrode (GE), a source electrode, and a drain electrode;
an interlayer insulating film (ILD) on the gate electrode (GE) of the thin film transistor (TFT);
a connection electrode (BE) on the interlayer insulating film (ILD), the connection electrode (BE) electrically connected to the thin film transistor (TFT);
an adhesive layer (AD) on the connection electrode (BE), the adhesive layer (AD) including adhesive material;
a planarization layer (P) on the adhesive layer (AD), wherein the adhesive layer (AD) and the planarization layer (P) is formed with a contact hole (CEH2) exposing at least a portion of the connection electrode (BE);
at least one micro light emitting diode, micro LED, (ED) disposed on at least a portion of the adhesive layer (AD), the micro LED (ED) including a semiconductor layer (NS2) and another semiconductor layer (NS1);
a wire electrode (CE2) electrically connecting the semiconductor layer (NS2) of the micro LED (ED) and the connection electrode (BE) through the contact hole (CEH2).

2. The display device (100, 200, 300, 400, 500, 600) of claim 1, further comprising a passivation layer (PS) covering a side surface of the semiconductor layer (NS2) or a side surface of the another semiconductor layer (NS1).

3. The display device (100, 200, 300, 400, 500, 600) of claim 2, wherein the planarization layer (P) covers a side surface of the passivation layer (PS).

4. The display device (100, 200, 300, 400, 500, 600) of any of claims 1 to 3, wherein the planarization layer (P) includes a first planarization layer (P1) and a second planarization layer (P2) on the first planarization layer (P1).

5. The display device (100, 200, 300, 400, 500, 600) of claim 4, wherein the second planarization layer (P2) is formed with a second contact hole exposing at least a portion of an electrode (E2) on the semiconductor layer (NS2), and wherein the wire electrode (CE2) is electrically connected to the electrode (E2) through the contact hole, and electrically connects the electrode (E2) to the connection electrode (BE),
wherein, preferably, the second planarization layer (P2) covers a side surface of the wire electrode (CE2) and a side surface of the electrode (E2).

6. The display device (100, 200, 300, 400, 500, 600) of any of claims 1 to 5, further comprising a bank (BNK) on the planarization layer (P), wherein the bank (BNK) fills at least a portion of the contact hole (CEH2).

7. The display device (100, 200, 300, 400, 500, 600) of claim 6, wherein the bank (BNK) includes a black material.

8. The display device (100, 200, 300, 400, 500, 600) of claim 6 or 7, wherein the bank (BNK) extends to cover at least a portion of the front panel region (FPN), a rear panel region (BPN), and the bending region (BDA).

9. The display device (100, 200, 300, 400, 500, 600) of any of claims 6 to 8, further comprising a sealing insulation layer (PTL) covering the bank (BNK), the planarization layer (P), and the wire electrode (CE2).

10. The display device (100, 200, 300, 400, 500, 600) of any of claims 1 to 9, further comprising a reflection layer (RF) disposed below the micro LED (ED), the reflection layer (RF) including a material that is configured to reflect light emitted from the micro LED (ED), wherein, preferably, the reflection layer (RF) is disposed below the adhesive layer (AD).

11. The display device (100, 200, 300, 400, 500, 600) of any of claims 1 to 10, wherein the interlayer insulating film (ILD) includes organic material.

12. The display device (100, 200, 300, 400, 500, 600) of any of claims 1 to 11, wherein the substrate (FSUB) is a flexible substrate.

13. The display device (100, 200, 300, 400, 500, 600) of any of claims 1 to 12, further comprising:
a first connection wire (LE) on the front panel region (FPN) of the substrate (FSUB), the first connection wire (LE) electrically connected to the micro LED (ED);
a side wire (SE) extending from the first connection wire (LE) on the bending region (BDA) of the substrate (FSUB), wherein a width of the side wire (SE) is wider than a width of the first connection wire (LE) or a width of a second connection wire (LE); and
the second connection wire (LE) extending from the side wire (SE) on the rear panel region (BPN) of the substrate (FSUB), the second connection wire (LE) electrically connected to an integrated circuit chip (IC).

14. The display device (100, 200, 300, 400, 500, 600) of any of claims 1 to 13, wherein the substrate (FSUB) is a single substrate formed of a transparent insulating material.

15. A tiling display device (TD), comprising:
a set of display devices (100-1, 100-2, ..., 100-M, 100-N), the set of display devices including the display device (100, 200, 300, 400, 500, 600) of any of claims 1 to 14, wherein each display device (100, 200, 300, 400, 500, 600) is electrically connected to an adjacent display device (100, 200, 300, 400, 500, 600),
wherein the bending region (BDA) of the display device (100, 200, 300, 400, 500, 600) of any of claims 1 to 14 is adjacent to another bending region (BDA) of a substrate (FSUB) of another display device (100, 200, 300, 400, 500, 600).
